# EUROPEAN PATENT APPLICATION

(11) **EP 1 936 397 A2**
(43) Date of publication of application: **25.06.2008**
(21) Application number: 07024456.1
(22) Date of filing: 17.12.2007
(51) Int. Cl.: G01R 31/34, G01R 31/12

(54) **Insulation deterioration detection device for motor**

(30) Priority: 21.12.2006 JP 2006344379
(71) Applicant: FANUC LTD, Minamitsuru-gun, Yamanashi 401-0597 (JP)
(72) Inventor: Horikoshi, Shinichi, Yamanashi 401-0597 (JP); Sato, Hiroyasu, Yamanashi 401-0597 (JP); Hirai, Akira, Yamanashi 401-0597 (JP); Tanabe, Satoshi, Yamanashi 401-0597 (JP); Yaeshima, Mamoru, Yamanashi 401-0597 (JP)
(74) Representative: Thum, Bernhard

(57) **Abstract**

A motor insulation deterioration detection device wherein a capacitor provided in a power supply section is utilized as a power supply for motor insulation deterioration detection, with provisions made to be able to detect insulation resistance regardless of the value of the voltage developed across the capacitor. The motor insulation deterioration detection device includes: a first contact which connects one end of the capacitor to ground; a second contact which connects the other end of the capacitor to a motor coil via a detection resistor; a unit which, using the detection resistor, detects a current flowing through a closed circuit formed by the first contact, capacitor, second contact, detection resistor, motor coil, and ground; a unit which detects the voltage developed across the capacitor; and a unit which calculates the insulation resistance value based on the current detection value and the voltage detection value.

## Description

### BACKGROUND OF THE INVENTION

### 1. Field of the Invention

The present invention relates to a device for detecting insulation deterioration within a motor.

### 2. Description of the Related Art

To ensure stable motor operation, it is essential to monitor the condition of insulation which deteriorates over time and to apply suitable measures when it is detected that the insulation has deteriorated. In view of this, various devices for detecting insulation deterioration within motors have been proposed in prior art. For example, Japanese Patent No. 3751300 discloses a device in which a smoothing capacitor used when converting an alternating current being fed from an AC power supply into a direct current is utilized as a power supply for motor insulation resistance detection.

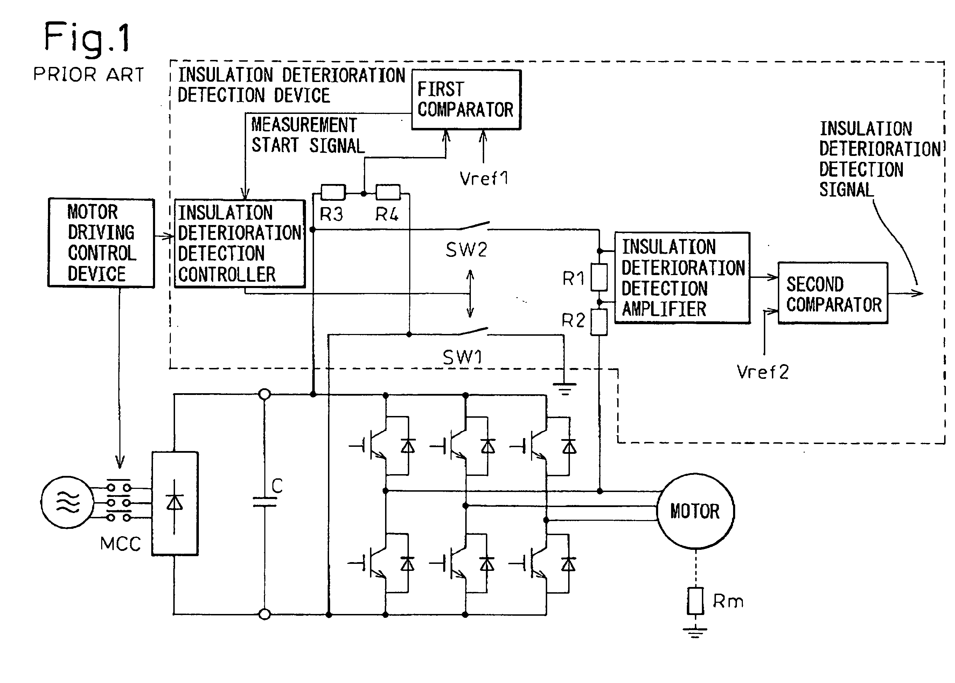

Figure 1 is a block diagram showing the configuration of a prior art motor insulation deterioration detection device along with its peripheral circuits in order to explain the prior art device described in Japanese Patent No. 3751300. As shown, AC output from a three-phase AC power supply is fed via electromagnetic contactor contacts MCC and a rectifier circuit to a smoothing capacitor C which is thus charged. When the charging is complete, a motor driving control device opens the electromagnetic contactor contacts MCC. Thereupon, the charge stored in capacitor C is released through resistors R3 and R4.

Here, a first comparator, which is provided to compare the voltage taken at the node between resistors R3 and R4 with a reference voltage Vref1, detects that the voltage of capacitor C has dropped to a predetermined voltage. At this point, the first comparator sends a measurement start signal to an insulation deterioration detection controller, and the insulation deterioration detection controller that received the signal closes contacts SW1 and SW2.

When contacts SW1 and SW2 are closed, a closed circuit is formed passing through capacitor C, resistors R1 and R2, a motor coil, and a motor insulation resistor Rm. Then, voltage developed across resistor R2, which is proportional to the current flowing through the closed circuit, is amplified by an insulation deterioration detection amplifier. If it is detected by a second comparator that the amplified voltage signal is larger than a reference voltage Vref2, i.e., if the leakage current exceeds a predetermined value for a given capacitor voltage, an insulation deterioration detection signal is output.

In the above prior art, measurement starts when the voltage across the capacitor drops to the predetermined voltage. This method is simple, but, since the measurement cannot be started until the voltage across the capacitor drops to the predetermined voltage, measurement time will vary. Furthermore, if the voltage divided between resistors R3 and R4 is lower than the reference value Vref1 from the beginning, the measurement cannot be performed. Further, the reference value must be changed according to the supplied voltage.

### SUMMARY OF THE INVENTION

The present invention has been made in view of the above problems, and an object of the invention is to provide an insulation deterioration detection device for a motor that is driven by a motor driving device comprising a power supply section in which power supplied from an AC power supply via a switch is rectified by a rectifier circuit and smoothed by a capacitor and a motor driving amplifier by which DC voltage supplied from the power supply section is converted into AC voltage for driving the motor, wherein the capacitor is utilized as a power supply for motor insulation deterioration detection, with provisions made to be able to detect the insulation resistance regardless of the value of the voltage developed across the capacitor.

To achieve the above object, according to the present invention, there is provided a device for detecting a deterioration of insulation within a motor that is driven by a motor driving device comprising a power supply section in which power supplied from an AC power supply via a switch is rectified by a rectifier circuit and smoothed by a capacitor and a motor driving amplifier by which a DC voltage supplied from the power supply section is converted into an AC voltage for driving the motor, the device comprising: a first contact which connects one end of the capacitor to ground; a second contact which connects the other end of the capacitor to a motor coil via a detection resistor; a unit which closes the first and second contacts in accordance with a signal output from the motor driving device for turning off the switch; a current detection unit which, using the detection resistor, detects a current flowing through a closed circuit formed by the first contact, capacitor, second contact, detection resistor, motor coil, and ground; a voltage detection unit which detects a voltage developed across the capacitor; and a calculation unit which calculates an insulation resistance value based on a detection value from the current detection unit and a detection value from the voltage detection unit.

In one preferred mode, the insulation deterioration detection device compares the insulation resistance value calculated by the calculation unit with a reference value, and outputs an insulation deterioration detection signal if the insulation resistance value is smaller than the reference value.

In the motor insulation deterioration detection device according to the present invention, since the insulation resistance value is calculated based on the current flowing through the closed circuit containing the capacitor as a power supply and the insulation resistor and on the voltage developed across the capacitor, insulation deterioration occurring within the motor can be detected regardless of the value of the voltage developed across the capacitor.

### BRIEF DESCRIPTION OF THE DRAWINGS

The features and advantages of the present invention will be made apparent from the following description with reference to the accompanying drawings, in which:
Figure 1 is a block diagram showing one configuration example of a prior art motor insulation deterioration detection device along with its peripheral circuits;
Figure 2 is a block diagram showing the configuration of one embodiment of a motor insulation deterioration detection device according to the present invention along with its peripheral circuits;
Figure 3 is a flowchart illustrating one example of the operation of the insulation deterioration detection device shown in Figure 2; and
Figure 4 is a flowchart illustrating another example of the operation of the insulation deterioration detection device shown in Figure 2.

### DETAILED DESCRIPTION

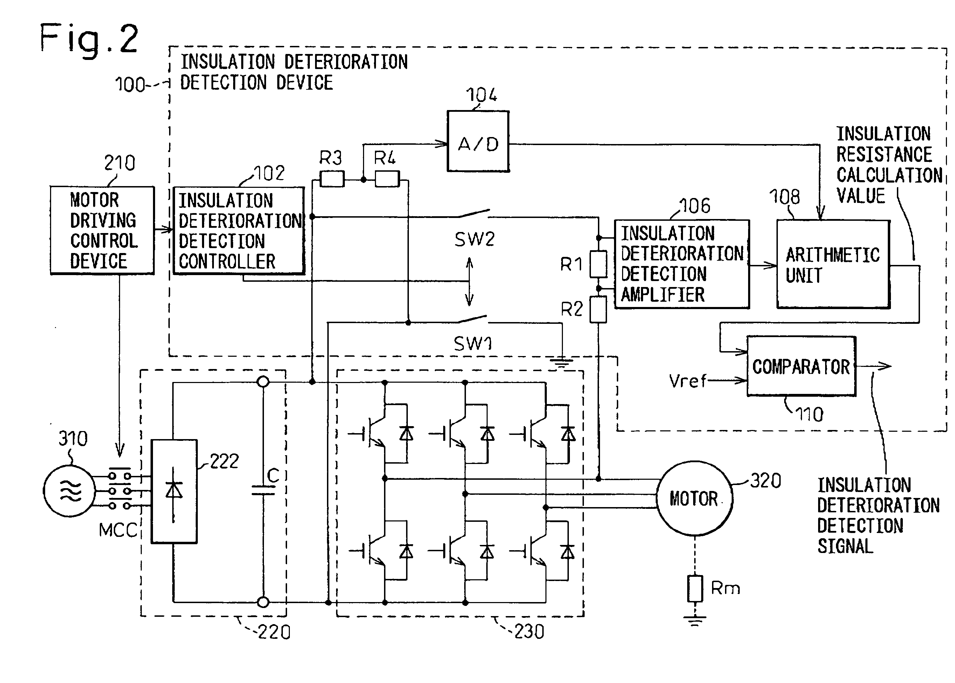

An embodiment of the present invention will be described with reference to the accompanying drawings. Figure 2 is a block diagram showing the configuration of one embodiment of a motor insulation deterioration detection device according to the present invention along with its peripheral circuits. In the figure, reference numeral 100 indicates the motor insulation deterioration detection device, 210 indicates a motor driving control device, 220 indicates a power supply section, 230 indicates a motor driving amplifier, 310 indicates a three-phase AC power supply, MCC represents electromagnetic contactor contacts, 320 indicates a motor, and Rm designates motor insulation resistance. Motor driving control device 210, power supply section 220, and motor driving amplifier 230 together constitute a motor driving device.

Power supply section 220 includes a rectifier circuit 222 and a smoothing capacitor C, and outputs DC power by rectifying and smoothing the power being supplied from three-phase AC power supply 310 via the electromagnetic contactor contacts MCC as a switch. Motor driving amplifier 230 is constructed as a three-phase voltage type PWM (Pulse Width Modulation) inverter formed from six transistor/diode pairs each comprising a diode connected in reverse parallel with a transistor, and converts DC voltage supplied from power supply section 220 into AC voltage to drive motor 320.

The insulation deterioration detection device 100 comprises contacts SW1 and SW2, resistors R1, R2, R3, and R4 (their resistance values are also designated by R1, R2, R3, and R4, respectively), an insulation deterioration detection controller 102, an analog/digital (A/D) converter 104, an insulation deterioration detection amplifier 106, an arithmetic unit 108, and a comparator 110. The contact SW1 is used to connect one end of the capacitor C to ground. The contact SW2 is used to connect the other end of the capacitor C to a coil of the motor 320 via the resistors R1 and R2. The voltage developed across the capacitor C is divided between the resistors R3 and R4.

The insulation deterioration detection controller 102 controls the contacts SW1 and SW2 by receiving a signal from the motor driving control device 210. The A/D converter 104 converts the voltage divided between the resistors R3 and R4 from an analog value to a digital value which is fed to the arithmetic unit 108. The amplifier 106 amplifies the voltage developed across the resistor R1 acting as a current detecting resistor, and supplies the result to the arithmetic unit 108. The arithmetic unit 108 calculates the value of the insulation resistance Rm (the value is also designated by Rm) of the motor 320 based on the output of the A/D converter 104 and the output of the amplifier 106. If the output of the arithmetic unit 108 is smaller than a reference voltage Vref, the comparator 110 outputs an insulation deterioration detection signal. The operation of the insulation deterioration detection device 100 will be described below.

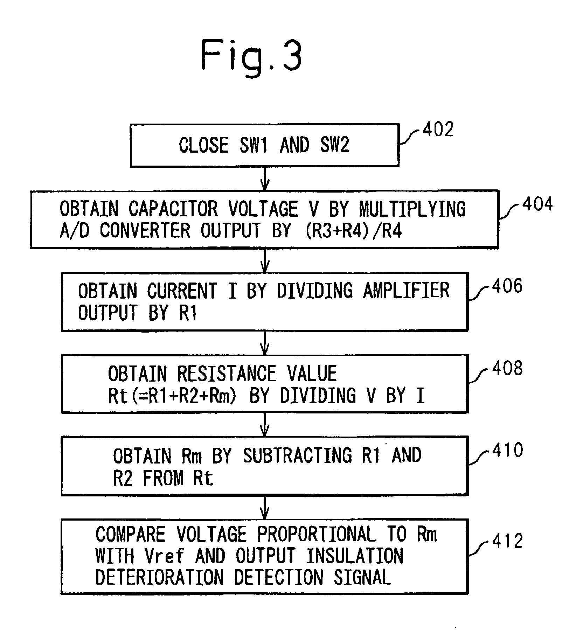

Figure 3 is a flowchart illustrating one example of the operation of the insulation deterioration detection device 100 shown in Figure 2. First, the controller 102 closes the contacts SW1 and SW2 by detecting that a signal for opening the electromagnetic contactor contacts MCC is output from the motor driving control device 210 (step 402).

Because of the presence of the insulation resistance Rm between the coil of the motor 320 and the ground, when the contacts SW1 and SW2 are closed, a closed circuit is formed passing through the contact SW1, capacitor C, contact SW2, resistors R1 and R2, motor coil, and ground. Accordingly, the relation V = RtxI holds in accordance with Kirchhoff's voltage law, where I is the current flowing through the closed circuit, V is the voltage across the capacitor C, and Rt is the resistance of the closed circuit. Further, since the resistance of each of the contacts SW1 and SW2 and the motor coil can be ignored, the relation Rt = R1+R2+Rm holds.

Next, the arithmetic unit 108 obtains the voltage V across the capacitor C by multiplying the output of the A/D converter 104 by (R3+R4)/R4 (step 404). The arithmetic unit 108 further obtains the current flowing through the resistor R1, i.e., the current I flowing through the closed circuit, by dividing the output value of the amplifier 106 by the resistance value R1 (step 406).

Next, the arithmetic unit 108 obtains the combined resistance Rt (= R1+R2+Rm) of the series connection of the resistors R1, R2, and Rm by dividing the voltage V by the current I (step 408). The arithmetic unit 108 further obtains the insulation resistance value Rm by subtracting the known resistance values R1 and R2 from the combined resistance value Rt (Rt-(R1+R2)), and outputs a signal voltage proportional to that value (step 410).

Finally, the comparator 110 compares the output signal voltage of the arithmetic unit 108 with the reference voltage Vref, and outputs an insulation deterioration detection signal if the output signal voltage is smaller than the reference voltage Vref, that is, if the insulation resistance value Rm is smaller than a reference resistance value (step 412).

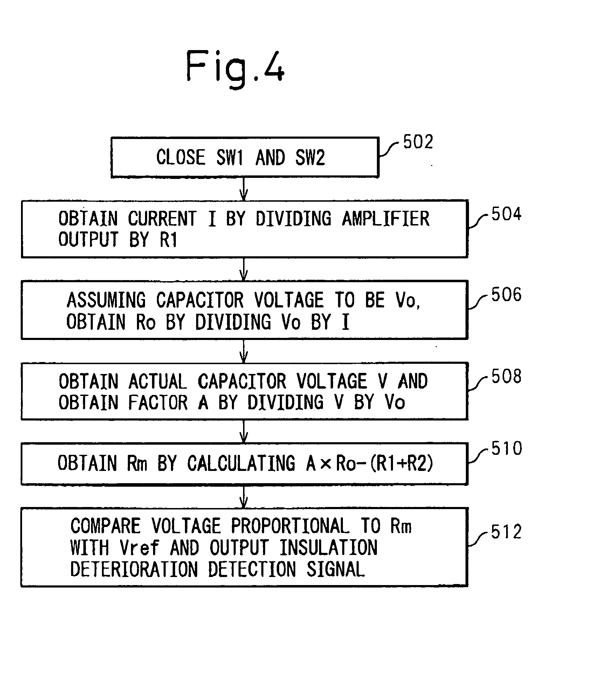

Figure 4 is a flowchart illustrating another example of the operation of the insulation deterioration detection device shown in Figure 2. First, the controller 102 closes the contacts SW1 and SW2 by detecting that a signal for opening the electromagnetic contactor contacts MCC is output from the motor driving control device 210 (step 502). When the contacts SW1 and SW2 are closed, the above-described closed circuit is formed.

Next, the arithmetic unit 108 obtains the current I flowing through the resistor R1, i.e., the current I flowing through the closed circuit, by dividing the output value of the amplifier 106 by the resistance value R1 (step 504). Then, by assuming that the voltage across the capacitor C is of a fixed value Vo, the arithmetic unit 108 obtains the resistance value Ro (= Vo/I) by dividing the fixed value Vo by the current I (step 506).

Next, the arithmetic unit 108 obtains the voltage V across the capacitor C by multiplying the output of the A/D converter 104 by (R3+R4)/R9, and obtains a factor A (= V/Vo) by dividing the voltage V by the fixed value Vo (step 508). Further, the arithmetic unit 108 obtains the insulation resistance value Rm by calculating A×Ro-(R1+R2), and outputs a signal voltage proportional to that value (step 510). Here, A×Ro (= V/I) represents the combined resistance Rt (= R1+R2+Rm) of the series connection of the resistors R1, R2, and Rm.

Finally, the comparator 110 compares the output signal voltage of the arithmetic unit 108 with the reference voltage Vref, and outputs an insulation deterioration detection signal if the output signal voltage is smaller than the reference voltage Vref, that is, if the insulation resistance value Rm is smaller than a reference resistance value (step 512).

In the above embodiment, unlike the prior art shown in Figure 1, since the value proportional to the voltage developed across the capacitor is A/D converted and input to the arithmetic unit to calculate the insulation resistance value of the motor, insulation deterioration occurring within the motor can be detected regardless of the value of the voltage developed across the capacitor.

The invention may be embodied in other specific forms. The present embodiment is therefore to be considered in all respects as illustrative and not restrictive, the scope of the invention being indicated by the appended claims rather than by the foregoing description and all changes which come within the meaning and range of equivalency of the claims are therefore intended to be embraced therein.

## Claims

1. A device (100) for detecting deterioration of insulation within a motor (320) that is driven by a motor driving device comprising a power supply section (220) in which power supplied from an AC power supply (310) via a switch (MCC) is rectified by a rectifier circuit (222) and smoothed by a capacitor (C) and a motor driving amplifier (230) by which DC voltage supplied from said power supply section (220) is converted into AC voltage for driving said motor, **characterized in that** said device comprises:
a first contact (SW1) which connects one end of said capacitor (C) to ground;
a second contact (SW2) which connects the other end of said capacitor (C) to a motor coil (320) via a detection resistor (R1);
a unit (102) which closes said first and second contacts (SW1 and SW2) in accordance with a signal output from said motor driving device for turning off said switch (MCC);
a current detection unit (106, 108) which, using said detection resistor (R1), detects a current flowing through a closed circuit formed by said first contact (SW1), said capacitor (C), said second contact (SW2), said detection resistor (R1), said motor coil (320), and ground;
a voltage detection unit (R3, R4, 104, 108) which detects a voltage developed across said capacitor; and
a calculation unit (108) which calculates an insulation resistance value based on a detection value from said current detection unit and a detection value from said voltage detection unit.

2. A device according to claim 1, wherein the insulation resistance value calculated by said calculation unit (108) is compared (110) with a reference value, and an insulation deterioration detection signal is output if said insulation resistance value is smaller than said reference value.
